# EUROPEAN PATENT SPECIFICATION

(11) **EP 0 903 754 B1**
(45) Date of publication and mention of the grant of the patent: **18.09.2002**
(21) Application number: 98121759.9
(22) Date of filing: 29.12.1992
(51) Int. Cl.: G11C 29/00, G11C 16/06

(54) **Nonvolatile semiconductor memory**
Nicht-flüchtige Halbleiter-Speicher-Vorrichtung
Dispositif de mémoire à semiconducteur non volatile

(30) Priority: 27.12.1991 JP 34666391
(43) Date of publication of application: 24.03.1999
(62) Divisional of application: 92311829.3
(73) Proprietor: FUJITSU LIMITED, Kawasaki-shi, Kanagawa 211-8588 (JP)
(72) Inventor: Akaogi, Takao, c/o Fujitsu Limited, Kawasaki-shi, Kanagawa 211-8588 (JP)
(74) Representative: Hitching, Peter Matthew

(56) References cited:
- WO-A-90/12400
- US-A- 4 875 188
- K. SEKI ET AL.: "An 80-ns 1-Mb Flash Memory with On-Chip rase/Erase-Verify Controller" IEEE JOURNAL OF SOLID-STATE CIRCUITS, no. 5, 5 October 1990, pages 1147-1151, XP000162797

## Description

This invention relates to a nonvolatile semiconductor memory, particularly to an EPROM and an EEPROM including a nonvolatile memory circuit and, more particularly to a circuit construction of a nonvolatile semiconductor memory of the batch erasure type (hereinafter referred to as a flash memory).

The invention further relates particularly to a circuit construction concerning a sense amplifying (S/A) circuit and supply of a supply voltage in a nonvolatile semiconductor memory.

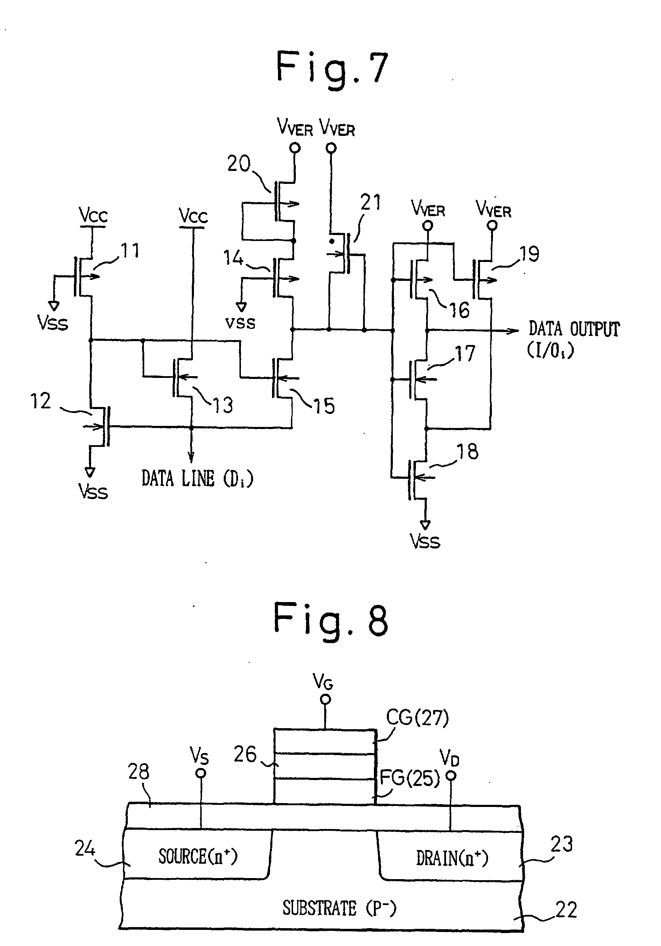

Fig. 8 of the accompanying drawings shows diagrammatically a structure of a cell used in a flash memory.

In this figure, indicated at V_{G} is a gate terminal, at V_{D} a drain terminal, at V_{S} a source terminal, at 27 a control gate CG connected to the gate terminal V_{G}, and at 25 a floating gate FG which is controlled by the potential of the control gate CG.

Further, indicated at 22 is a semiconductor substrate, e.g. a semiconductor substrate having P-type conductivity. On the semiconductor substrate 22 are mounted well portions 23, 24 made of semiconductor having N-type conductivity. The well portion 23 forms a drain while the well portion 24 forms a source. Indicated at 26, 28 are insulating films.

When data is read from the cell, 0V is applied to the source terminal V_{S}, a read voltage (normal supply voltage V_{CC}) of 5V is applied to the gate terminal V_{G}, and a voltage of about 1V is applied to the drain terminal V_{D}. Then, it is discriminated whether the read data is "1" or "0" depending upon whether a current flows through the cell. On the other hand, when data is written in the cell, 0V is applied to the source terminal V_{S}, a write/erase voltage V_{PP} of about 12V is applied to the gate terminal V_{G}, and a write drain voltage V_{W} (lower than V_{PP}) is applied to the drain terminal V_{D}. Thereby, electrons are injected into the floating gate FG from a drain region (writing operation). Further, when the data is erased, the drain terminal V_{D} is brought into an open state, and 0V and the write/erase voltage V_{PP} are applied to the gate terminal V_{G} and the source terminal V_{S} respectively. Thereby, the electrons are taken from the floating gate FG to a source region (erasing operation).

When the data is written, it is required to check whether the data is written sufficiently in the memory cell (write verification). Likewise, when the data is erased it is required to check whether the data is erased sufficiently from the memory cell (erase verification).

The write verification and erase verification are carried out so as to confirm whether the degree of writing and the degree of erasing have a sufficient margin for the read voltage, i.e., a variation range of the normal supply voltage V_{CC} (5V ± 0.5V). Generally, these verifications are carried out to confirm that an operation margin of about 0.5V to 1.0V is available for a voltage range of V_{CC}. In this case, the verify voltage including the operation margin is 6V to 6.5V in the write verification, and 3.5V to 4V in the erase verification.

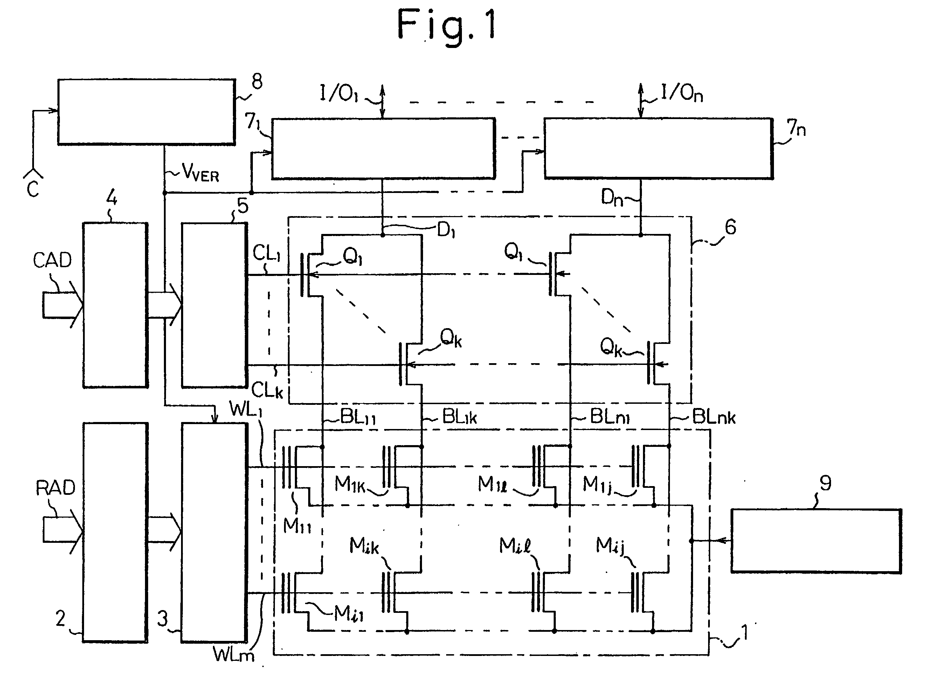

It is expected that the write verification and the erase verification can be accomplished easily if the verify voltage including the operation margin to be secured is applied to word lines (for example, word lines WLₗ to WLₘ of the flash memory shown in Fig. 1), so that the sensitivity of the S/A circuit is the same regardless of whether the voltage V_{CC} or the verify voltage is applied as the supply voltage of the S/A circuit.

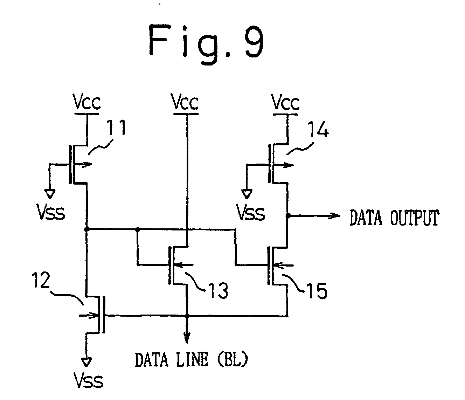

Fig. 9 of the accompanying drawings shows a construction of a general S/A circuit used in the nonvolatile semiconductor memory such as an EPROM.

In this figure, indicated at V_{CC} is a line of a supply voltage 5V, and at V_{SS} a line of a supply voltage 0V. Between the power supply lines V_{CC} and V_{SS} are connected a p-channel transistor 11 and an n-channel transistor 12 in series. A gate of the transistor 11 is connected to power supply line V_{SS}, while a gate of the transistor 12 is connected to a data line (i.e. a bit line). Between the power supply line V_{CC} and the data line is connected an n-channel transistor 13 whose gate is connected to drains of the respective transistors 11, 12. Likewise, between the power supply line V_{CC} and the data line are connected a p-channel transistor 14 and an n-channel transistor 15 in series. A gate of the transistor 14 is connected to the power supply line V_{SS}, while a gate of the transistor 15 is connected to the drains of the respective transistors 11, 12. An output (data output) of the S/A circuit is taken from drains of the respective transistors 14, 15.

In this construction, when the data read from the memory cell is "1", i.e. when the level of the data line is "H", the transistor 12 is turned on and thereby a drain potential thereof is reduced to "L" level. Accordingly, the transistor 15 is cut off. Thus, the voltage of "H" level is output from the power supply line V_{CC} through the transistor 14 (data output). In other words, the data having the same level as the read data is sensed. Conversely, when the data read from the memory cell is "0", the transistor 12 is cut off and the voltage of "H" level is fed from the power supply line V_{CC} through the transistor 11 to the gate of the transistor 15 to turn the transistor 15 on. Thereupon, the level of a data output line is reduced to "L" (the data of "L" level is the same as the read data).

In this way, the transistor 15 is provided with a function of transmitting the level of the bit line to the data output line (bit line level adjustment), and the transistor 14 is provided with a function of discriminating the data of the memory cell according to the state (on/off) of the transistor 15.

In the construction of the conventional S/A circuit as described above, the sensitivity of the S/A circuit becomes dependent on the voltage V_{cc} since the voltage V_{cc} is used as a supply voltage, thus presenting the problem that an original object of the verification cannot be accomplished.

On the other hand, the desired object can be accomplished if the voltage V_{cc} is replaced by the verify voltage. However, since all the power to be consumed by the S/A circuit must be supplied by the verify voltage, the size, i.e. the current supplying performance of a power supply circuit for supplying the verify voltage is disadvantageously required to be increased.

An embodiment of the present invention seeks to provide a nonvolatile semiconductor memory in which an S/A circuit is permitted to have the sensitivity compatible with any of a write verification and an erase verification even if a normal supply voltage is used, that is; a verification can be conducted sufficiently.

WO-A-90/12400 discloses a nonvolatile semiconductor memory which may be considered to have circuitry including a matrix of nonvolatile erasable memory cells formed at intersections of word lines and bit lines, a row decoder, a column decoder, and sense amplifiers connected to the bit lines, the nonvolatile semiconductor memory being adapted for connection, when in use, to external power source means to receive therefrom a normal source voltage, required by the said circuitry for performing a normal reading operation on one of the said. memory cells, and a predetermined verify source voltage, required by said circuitry for performing a preselected verify operation on one of the said memory cells; and power delivery means operable during such a preselected verify operation to deliver the received verify source voltage to the or each word line selected in the operation concerned whilst delivering the received normal source voltage to remaining parts of said circuitry. An external power source supplies a normal source voltage Vcc and a verify source voltage Vcc±δV to the memory during a verify operation. The selected sense amplifier is supplied exclusively by the verify source voltage during the verify operation.

Another electrically erasable nonvolatile memory is disclosed in "An 80-ns 1-Mb flash memory with on-chip erase/erase-verify controller", IEEE Journal of Solid-State Circuitry 25 (1990) October, No. 5, New York US, pp. 1147-1149. This flash memory has an on-chip verify voltage generator which supplies to word decoders and sense amplifiers a verify source voltage of 3.4V during an erase-verify and a normal source voltage of 5V in usual read operations.

A nonvolatile semiconductor memory embodying the present invention is characterised in that during said preselected verify operation said power delivery means serve to deliver said verify source voltage to a transistor included in the or each selected sense amplifier that is used for discriminating the data stored in the memory cell being verified, whilst serving to deliver said normal source voltage to remaining parts of the selected sense amplifier.

Specifically, in one embodiment the sense amplifiers (sense amplifying (S/A) circuits) have two different kinds of source voltages supplied thereto and are adapted to apply sense amplification to data of the selected line in the matrix.

According to a second embodiment of the present invention there is provided an apparatus including: a nonvolatile semiconductor memory embodying the aforesaid first aspect of the present invention; and external power source means provided with a normal source voltage supplying circuit for generating said normal source voltage and with a verify source voltage supplying circuit for generating said verify source voltage, the voltage level of the verify source voltage being different from that of said normal source voltage at least when a write verify operation or an erase verify operation is being carried out by the nonvolatile semiconductor memory.

The nonvolatile semiconductor memory in one embodiment is provided with external source voltage supplying means having a normal source voltage generating circuit and also having a specific verify source voltage generating circuit capable of generating a source voltage different from the normal source voltage in the write verify operation and the erase verify operation, respectively. The two different kinds of source voltages (i.e. the normal source voltage and a specific verify source voltage different from the normal source voltage) are generated, in accordance with a control signal for instructing a write verification or erase verification, during the verification and the verify source voltage is applied to the selected word line and to a data-discriminating transistor in the selected S/A circuit.

With the above construction, the specific verify source voltage different from the normal source voltage V_{cc} is applied to a data discriminating transistor in the S/A circuit during the write verification or erase verification, and also to the selected word line. Accordingly, the sensitivity of the S/A circuit to the normal source voltage during a reading operation can be made equal to that of the S/A circuit to the verify source voltage during the verification. Further, margins during a data writing operation and an erasing operation can be checked sufficiently.

The specific verify source voltage generating circuit in the external power source voltage supplying means is used to reduce or boost an external source voltage of, e.g., 5V, to a specified verify source voltage level V_{VER}. However, the size of the verify source voltage generating circuit is determined by the places to which the verify source voltage needs to be supplied. Accordingly, a preferred feature of the invention is to limit the places where the verify source voltage is supplied.

In this way, the reading operation can be executed in the same state as in the prior art by supplying the verify source voltage to limited places. This enables a capacity of the external verify source voltage supply circuit to be small.

Any one of the normal source voltage and the specific verify source voltage can be selected by a predetermined controlling signal.

Reference will now be made, by way of example, to the accompanying drawings, in which:
Fig. 1 is an overall construction diagram showing a flash memory in an embodiment of the present invention;
Fig. 2 is a circuit diagram showing an exemplary construction of an S/A circuit in Fig. 1;
Fig. 3 is a graph showing a characteristic of the S/A circuit in Fig. 2;
Fig. 4 is a construction diagram of a verify voltage supply circuit in Fig. 1;
Fig. 5 is a circuit diagram showing another exemplary construction of the S/A circuit in Fig. 1;
Fig. 6 is a graph showing an ideal sensing characteristic;
Fig. 7 is a circuit diagram showing an exemplary construction of the S/A circuit in order to realize the characteristic shown in Fig. 6;
Fig. 8 is a diagram showing a cell structure for explaining an operation of the flash memory;
Fig. 9 is a circuit diagram showing a construction of the S/A circuit as an example of the prior art;

Fig. 1 is a block diagram showing parts of an overall construction of a flash type memory as a specific example of a nonvolatile semiconductor memory embodying the present invention.

In this figure, indicated at 1 is a cell array formed by arranging erasable nonvolatile memory cells Mᵢⱼ at intersections of a plurality of word lines WLₗ to WLₘ and a plurality of bit lines BL₁ₗ to BL₁ₖ, ..., BLₙₗ to BLₙₖ. In this embodiment, the cell array is divided into n blocks, in each of which (k × m) memory cells are arranged. Indicated at 2 is a row address buffer for buffering a row address RAD of an address signal fed externally thereto, at 3 a row decoder for decoding the row address and selecting any one of the word lines WLₗ to WLₘ, at 4 a column address buffer for buffering a column address CAD of the address signal, and at 5 a column decoder for decoding the column address and selecting any one of column lines CLₗ to CLₖ corresponding to the bit lines BLiₗ to BLiₖ for each of the aforementioned blocks. Indicated at 6 is a column gate circuit including transfer gate transistors Qₗ to Qₖ corresponding to the bit lines BLᵢₗ to BLᵢₖ for each of the aforementioned blocks. The respective transistors Qₗ to Qₖ are turned on when the corresponding column lines CLₗ to CLₖ are selected, to thereby connect the selected bit line BLᵢⱼ to a data line Dᵢ.

Indicated at 7ₗ to 7ₙ are respectively writing circuits and S/A circuits for applying amplification to a write data and sense amplification to a read data between corresponding internal data lines Dₗ to Dₙ and external input/output data lines I/Oₗ to I/Oₙ. Indicated at 8 is a verify source voltage generating circuit (part of external power source means) for generating a verify voltage V_{VER} in accordance with a control signal C fed externally thereto. The generated verify source voltage V_{VER} is supplied to the selected word lines WLₗ to WLₘ through the row decoder 3 as described later, and to the S/A circuit corresponding to the selected word line. Indicated at 9 is a source voltage supply circuit for supplying a source voltage in common to the respective sources of the non-volatile memory cells Mᵢⱼ.

It is desirable to set the erase verify voltage V_{E} lower than the normal source voltage (V_{CC}) and to set the write verify source voltage V_{W} higher than the normal source voltage (V_{CC}). Preferably, the normal supply voltage (V_{CC}) is an intermediate value between a first verify voltage which is the erase verify voltage and a second verify voltage which is the write verify voltage.

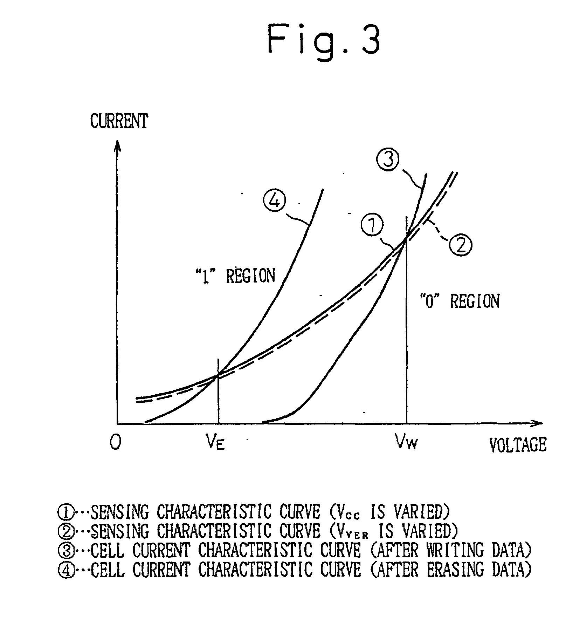

In this case, the desirable range of the write verify source voltage V_{W} and the erase verify source voltage V_{E} can be determined with reference to the graphs as shown in Fig. 3.

Note that when the erase verify source voltage V_{E} is selectively set at the voltage level close to or exactly at the crossing point formed by the characteristic curve of the sense amplifier ((1) or (2)) and the cell current characterisitic curve (after data is erased ) (4), and the write verify source voltage V_{W} is selectively set at the voltage level close to or exactly at the crossing point formed by the characteristic curve of the sense amplifier ((1) or (2)) and the cell current characteristic curve (after data is written) (3), the accurate discrimination for the verification can be obtained.

Accordingly, if the write verify signal WV is set at "H" level during the write verification, the transistor 34 is turned on. Thus, the potential at the node of the resistors 31, 32, i.e. the voltage of 6.5V, is applied to the connection node between the transistors 36, 37, and the verify voltage V_{VER} of 6.5V can be obtained by a current mirror action. On the other hand, if the erase verify signal EV is set at "H" level during the erase verification, the transistor 35 is turned on. Thus, the potential at the node of the resistors 32, 33, i.e. the voltage of 3.5V, is applied to the connection node between the transistors 36, 37 and the verify voltage V_{VER} of 3.5V can be obtained by the current mirror action. If the write verify signal WV and the erase verify signal EV are both set at "H" level during the normal reading operation, the transistors 34, 35 are cut off. As a result, only the current mirror circuit operates and an intermediate level (5V) between 6.5V and 3.5V is output as the output voltage V_{VER}. This output voltage is at the same level as the normal supply voltage V_{CC}.

Since an output signal of the S/A circuit is normally a weak signal in terms of the amplitude and drive ability, it is preferable to provide a buffer circuit for the purpose of stabilizing the output signal.

In the case of the flash type memory, in which the voltage is changed from the bit line potential (about 1V) to the verify voltage V_{VER} during the verification, it is preferable to supply the verify voltage V_{VER} as a source voltage of the buffer circuit.

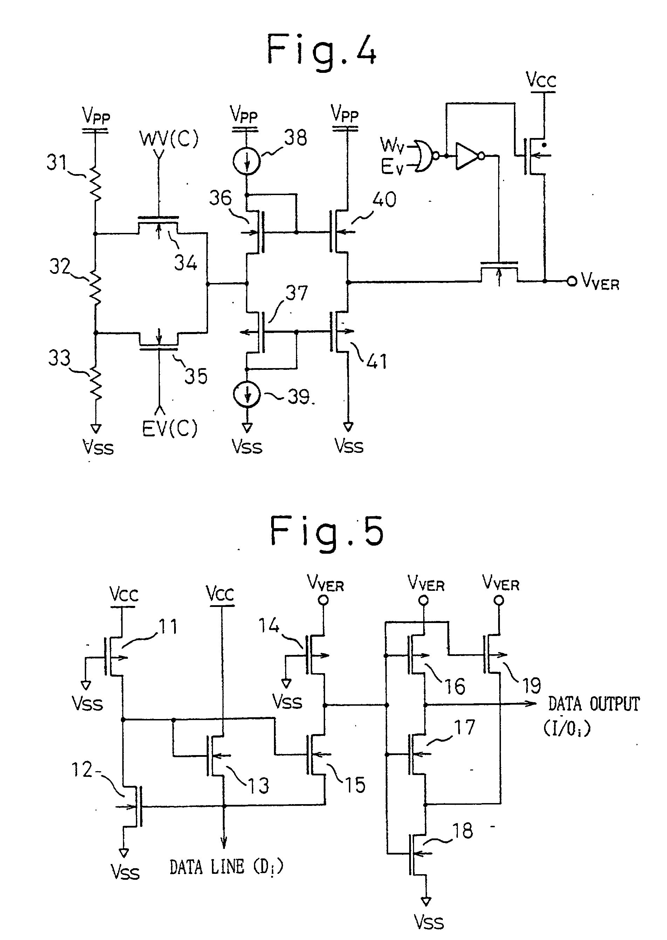

Fig. 5 shows an example of a construction of the S/A circuit including a buffer circuit.

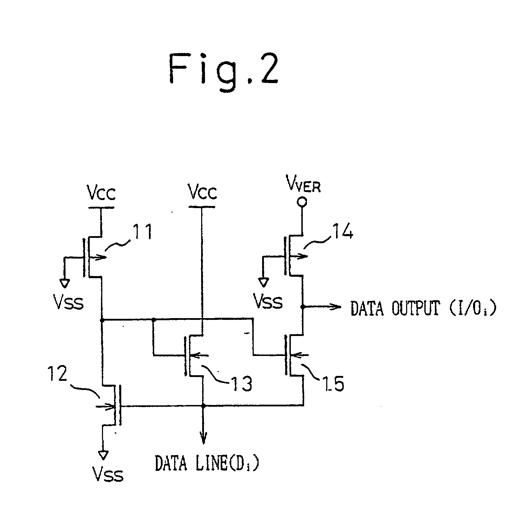

The illustrated circuit is obtainable by adding the buffer circuit to the construction of Fig. 2. This buffer circuit includes a p-channel transistor 16 and n-channel transistors 17, 18 which are connected in series between the verify source voltage line V_{VER} and the power supply line V_{SS} and which are responsive to the drain potentials of the respective transistors 14, 15; and a p-channel transistor 19 which is connected between the voltage line V_{VER} and a connection node between the transistors 17, 18 and which is responsive to the drain potentials of the respective transistors 14, 15. In this case, the output of the S/A circuit (data output) is taken from the drains of the respective transistors 16, 17.

In consideration of the operation of the flash type memory, the sense characteristic curves shown in Fig. 3 are ideally required to be devised. For example, the inclination of the sense characteristic curve is preferably large in the neighborhood of the write verify source voltage V_{W} so that a large power supply margin is taken for a change of a threshold voltage of the cell transistor. Conversely, the inclination of the sense characteristic curve is preferably small in the neighborhood of the erase verify source voltage V_{E} so as to make it easier to adjust the voltage V_{E} finely and in order to improve the stability of the characteristic in terms of differences among cell transistors.

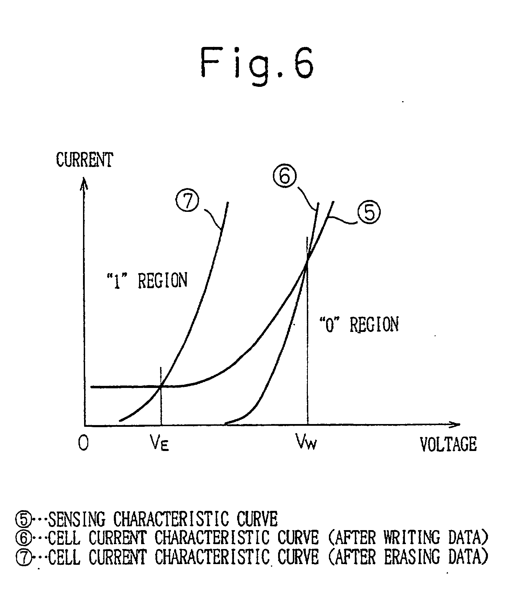

Fig. 6 shows ideal sense characteristic curves, and Fig. 7 shows an example of a construction of a preferable S/A circuit for realizing this characteristic.

The illustrated circuit is obtainable by adding two transistors 20 and 21 to the construction of the S/A circuit including the buffer circuit shown in Fig. 5. The transistor 20 is a p-channel transistor, and is connected between the verify source voltage V_{VER} and the source of the transistor 14. A gate of the transistor 20 is connected to a drain thereof. Accordingly, this transistor 20 functions as a voltage reducing element. On the other hand, the transistor 21 is an n-channel transistor of the depletion type, and is connected between the voltage V_{VER} and the commonly-connected drains of the transistors 14,15. A gate of the transistor 21 is connected to a source thereof. Accordingly, this transistor 21 functions as a constant current supplying element.

In this construction, when the verify source voltage V_{VER} is at low level, the drain potential of the voltage reducing transistor 20 is reduced accordingly. Thus, the transistor 14 is cut off and only the transistor 21 for the constant current load is turned on. In other words, there is realized a steeply inclined portion of the sense characteristic in the neighborhood of the erase verify source voltage V_{E} shown in Fig. 6. On the contrary, when the verify source voltage V_{VER} is at a relatively high level, the drain potential of the transistor 20 increases accordingly, and the transistor 14 is turned on. In other words, the transistors 21, 14 are both turned on, thereby realizing a gently inclined portion of the sense characteristic curve in the neighbourhood of the write verify voltage V_{W} shown in Fig. 6.

As described above, in a memory embodying the present invention, the portion of the overall memory circuit to which the verify source voltage should be applied, may be confined just to the selected word line and the transistor used for comparing with a voltage level provided in the sense amplifier. Note, that in accordance with the present invention, the number of the portions to which the verify source voltage should be applied in the verify operation can be significantly reduced as compared with the conventional method in which the source voltage V_{CC} applied to each of the components provided in the memory circuit is simply and uniformly converted to the verify source voltage. Accordingly, in the present invention, the number of the circuit elements to which the source voltage should be applied is remarkably small, thereby making it possible to reduce the performance required of the verify source voltage generating circuit used for supplying the verify source voltage. Accordingly, this generating circuit can be made significantly smaller than the comparable generating circuit required by the conventional method and thus the area to be occupied by the verify source voltage generating circuit can be significantly reduced whilst still maintaining suitable sensitivity in the verifying operation.

## Claims

1. A nonvolatile semiconductor memory having circuitry including a matrix (1) of nonvolatile erasable memory cells (Mij) formed at intersections of word lines (WL1 to WLm) and bit lines (BL11 to BL1k,..., BLn1 to BLnk), a row decoder (3), a column decoder (5), and sense amplifiers (71 to 7n) connected to the bit lines, the nonvolatile semiconductor memory being adapted for connection, when in use, to external power source means to receive therefrom a normal source voltage (Vcc), required by said circuitry for performing a normal reading operation on one of the said memory cells, and a predetermined verify source voltage (V_{WVER}/V_{EVER}), required by the said circuitry for performing a preselected verify operation on one of the said memory cells; and power delivery means operable during such a preselected verify operation to deliver the received verify source voltage (V_{WVER}/V_{EVER}) to the or each word line (WL1 to WLm) selected in the operation concerned whilst delivering the received normal source voltage (V_{CC}) to remaining parts (1-7) of said circuitry; **characterised in that** during said preselected verify operation said power delivery means serve to deliver said verify source voltage to a transistor (14) included in the or each selected sense anplifier (7i) that is used for discriminating the data stored in the memory cell being verified, whilst serving to deliver said normal source voltage (V_{CC}) to remaining parts (11, 13) of the selected sense amplifier.

2. The nonvolatile semiconductor memory according to claim 1, wherein an input terminal of each of the sense amplifiers (7i), at which terminal the verify source voltage (W_{WVER}/V_{EVER}) is applied to the sense amplifier concerned, has means (14) for providing a load-resistance function.

3. The nonvolatile semiconductor memory according to any preceding claim, wherein each of the sense amplifiers (7i) comprises:
a load-resistance element (14); and
a level-transmission transistor (15) connected in series with the load-resistance element (14) between the verify source voltage (V_{VER}) and a data line (Di) of said circuitry that corresponds to a plurality of said bit lines (BLi1 to BLik);
a node, at which the load-resistance element (14) is connected to the level-transmission transistor (15), being connected to an output end (I/Oi) of the sense amplifier (7i);
the level-transmission transistor (15) serving to transmit a level of the data line to the output end (I/Oi); and
the load-resistance element (14) serving to distinguish cell data on the data line (Di) according to an ON/OFF state of the level-transmission transistor (15).

4. The nonvolatile semiconductor memory according to claim 3, wherein:
the load-resistance element (14) is a p-channel transistor whose source, gate, and drain are connected respectively to the verify source voltage (V_{WVER}/V_{EVER}), a reference voltage (V_{SS}), and said output end (I/Oi) of the sense amplifier (7i); and
said level-transmission transistor (15) is an n-channel transistor whose drain, gate, and source are connected respectively to the output end (I/Oi) of the sense amplifier (7i), a node providing an inversion of the data line level, and the data line (Di).

5. The nonvolatile semiconductor memory according to 'claim 3 or 4, further comprising:
a buffer circuit (16 to 19), disposed at the output end of the sense amplifier, and having the verify source voltage (V_{VER}) as its source voltage.

6. The nonvolatile semiconductor memory according to claim 3, 4 or 5, further comprising:
a voltage drop element (20) connected between the verify source voltage (V_{VER}) and the load-resistance element (14); and
a constant current element (21) connected between the verify source voltage and the output end of the sense amplifier.

7. The nonvolatile semiconductor memory according to claim 6, wherein the voltage drop element is a p-channel transistor (20) whose gate is connected to its drain.

8. The nonvolatile semiconductor memory according to claim 6 or 7, wherein the constant current element is an n-channel transistor (21) whose gate is connected to its source.

9. The nonvolatile semiconductor memory according to any preceding claim, further comprising:
a power source (9) for supplying an external source voltage to the source of each transistor of each of the nonvolatile memory cells.

10. Apparatus including:
a nonvolatile semiconductor memory as claimed in any preceding claim; and
external power source means provided with a normal source voltage supplying circuit for generating said normal source voltage (V_{CC}) and with a verify source voltage supplying circuit (8) for generating said verify source voltage (V_{WVER}/V_{EVER}), the voltage level of the verify source voltage being different from that of said normal source voltage at least when a write verify operation or an erase verify operation is being carried out by the nonvolatile semiconductor memory.

11. Apparatus according to claim' 10, wherein said verify power source voltage supplying circuit (8) is selectively controllable to generate a write verify source voltage (V_{WVER}) and an erase verify source voltage (V_{EVER}) that is different from the write verify source voltage.

12. Apparatus according to claim 11, wherein the write verify source voltage (V_{WVER}) is higher than the normal source voltage (V_{CC}) and the erase verify source voltage (V_{EVER}) is lower than the normal source voltage (V_{CC}).

13. Apparatus according to claim 10, wherein said external power source means selects either said normal source voltage supplying circuit or said verify source voltage supplying circuit in response to a predetermined controlling signal, and said verify source voltage supplying circuit generates one of the write verify source voltage and the erase verify source voltage in response to a control signal.

14. Apparatus according to claim 11, wherein the verify source voltage supplying circuit comprises:
voltage dividers (31 to 33) for deriving from a write/erase voltage (Vpp) a first verify voltage suitable for a write verify operation and a second verify voltage suitable for an erase verify operation;
gate circuits (34, 35) for passing the first verify voltage in response to a write verify signal (WV) and for passing the second verify voltage in response to an erase verify signal (EV); and
circuits (36 to 41) having a current mirror configuration for providing said predetermined verify source voltage (V_{VER}) corresponding to that one of the first and second verify voltages which is passed through the gate circuits.

## Patentansprüche

1. Nichtflüchtiger Halbleiterspeicher mit einer Schaltung, die eine Matrix (1) aus nichtflüchtigen löschbaren Speicherzellen (Mij) umfaßt, die an Schnittpunkten von Wortleitungen (WL1 bis WLm) und Bitleitungen (BL11 bis BL1k, ..., BLn1 bis BLnk) angeordnet sind, einem Reihendecoder (3), einem Spaltendecoder (5) und Leseverstärkern (7i bis 7n), die mit den Bitleitungen verbunden sind, welcher nichtflüchtige Halbleiterspeicher angepaßt ist zur Verbindung, im Betrieb, mit externen Energiequellenmitteln, um davon eine normale Sourcespannung (V_{CC}) zu empfangen, die von der Schaltung benötigt wird, um einen normalen Lesebetrieb auf einer der genannten Speicherzellen durchzuführen, und eine vorbestimmte Verifizierungs-Sourcespannung (V_{WVER}/V_{EVER}), die von der genannten Schaltung benötigt wird, um eine vorausgewählte Verifizierungsoperation auf einer der genannten Speicherzellen durchzuführen; und
Energieliefermitteln, die während solch einer vorausgewählten Verifizierungsoperation betätigbar sind, um die empfangene Verifizierungs-Sourcespannung (V_{WVER}/V_{EVER}) an eine oder jede Wortleitung (WL1 bis WLm) zu liefern, die während der betreffenden Operation ausgewählt wird, während sie die empfangene normale Sourcespannung (V_{CC}) an die verbleibenden Teile (1 - 7) der Schaltung liefern;
**dadurch gekennzeichnet, daß** während der vorausgewählten Verifizierungsoperation die Energieliefermittel dazu dienen, die Verifizierungs-Sourcespannung an einen Transfertransistor (14) zu liefern, der in dem ausgewählten Leseverstärker (7i) enthalten ist, welcher zur Unterscheidung der in der Speicherzelle, die zu verifizieren ist, gespeicherten Daten dient, während sie die normale Sourcespannung (V_{CC}) an die verbleibenden Teile (11, 13) des ausgewählten Leseverstärkers liefern.

2. Nichtflüchtiger Halbleiterspeicher nach Anspruch 1, bei dem ein Eingangsanschluß von jedem der Leseverstärker (7i), auf welchen Anschluß die Verifizierungs-Sourcespannung (V_{WVER}/V_{EVER}) für den betreffenden Leseverstärker aufgebracht wird, Mittel (14) hat, um eine Last-Widerstandsfunktion vorzusehen.

3. Nichtflüchtiger Halbleiterspeicher nach einem der vorhergehenden Ansprüche, bei dem jeder der Leseverstärker (7i) umfaßt:
ein Last-Widerstandselement (14), und
einen Pegel-Übertragungstransistor (15), der in Reihe mit dem Last-Widerstandselement (14) zwischen der Verifizierungs-Sourcespannung (V_{VER}) und einer Datenleitung (Di) der genannten Schaltung verbunden ist, welche einer Vielzahl der genannten Bitleitungen (BLi1 bis BLik) entspricht,
einem Knotenpunkt, bei dem das Last-Widerstandselement (14) mit dem Pegel-Transmissionstransistor (15) verbunden ist, der mit einem Ausgangsende (I/Oi) des Leseverstärkers (7i) verbunden ist,
wobei der Pegel-Transmissionstransistor (15) dazu dient, einen Pegel der Datenleitung auf das Ausgangsende (I/Oi) zu übertragen, und
das Last-Widerstandselement (14) dazu dient, alle Zellen auf der Datenleitung (Di) entsprechend einem EIN/AUS-Zustand des Pegel-Transmissionstransistors (15) zu unterscheiden.

4. Nichtflüchtiger Halbleiterspeicher nach Anspruch 3, bei dem:
das Last-Widerstandselement (14) ein p-Kanal-Transistor ist, dessen Source, Gate und Drain mit der Verifizierungs-Sourcespannung (V_{WVER}/V_{EVER}), einer Referenzspannung (V_{SS}) bzw. dem genannten Ausgangsende (I/Oi) des Leseverstärkers (7i) verbunden sind, und
wobei der Pegel-Transmissionstransistor ein n-Kanal-Transistor ist, dessen Drain, Gate und Source mit dem Ausgangsende (I/Oi) des Leseverstärkers (7i), einem Knoten, der eine Inversion des Datenleitungspegels vorsieht, bzw. der Datenleitung (Di) verbunden sind.

5. Nichtflüchtiger Halbleiterspeicher nach Anspruch 3 oder 4, ferner umfassend:
eine Pufferschaltung (16 bis 19), die an dem Ausgangsende des Leseverstärkers vorgesehen ist und die Verifizierungs-Sourcespannung (V_{VER}) als ihre Sourcespannung hat.

6. Nichtflüchtiger Halbleiterspeicher nach Anspruch 3, 4 oder 5, ferner umfassend:
ein Spannungsabfallelement (20), das zwischen der Verifizierungs-Sourcespannung (V_{VER}) und dem Last-Widerstandselement (14) verbunden ist, und
ein Konstantstromelement (21), das zwischen der Verifizierungs-Sourcespannung und dem Ausgangsende des Leseverstärkers verbunden ist.

7. Nichtflüchtiger Halbleiterspeicher nach Anspruch 6, bei dem das Spannungsabfallelement ein p-Kanal-Transistor (20) ist, dessen Gate mit seinem Drain verbunden ist.

8. Nichtflüchtiger Halbleiterspeicher nach Anspruch 6 oder 7, bei dem das Konstantstromelement ein n-Kanal-Transistor (21) ist, dessen Gate mit seiner Source verbunden ist.

9. Nichtflüchtiger Halbleiterspeicher nach einem der vorhergehenden Ansprüche, ferner umfassend:
eine Energiequelle (9), um eine externe Sourcespannung an die Source von jedem Transistor jeder nichtflüchtigen Speicherzelle zu liefern.

10. Vorrichtung enthaltend:
einem nichtflüchtigen Halbleiterspeicher nach einem der vorhergehenden Ansprüche, ferner mit einem externen Energiequellenmittel, welches mit einer normalen Sourcespannungs-Lieferschaltung zur Erzeugung der genannten normalen Sourcespannung (V_{CC}) vorgesehen ist, und mit einer Verifizierungs-Sourcespannungs-Lieferschaltung (8), zum Erzeugen der Verifizierungs-Sourcespannung (V_{WVER}/W_{EVER}), wobei der Spannungspegel der Verifizierungs-Sourcespannung verschieden ist von der normalen Sourcespannung, zumindest wenn eine Schreib-Verifizierungsoperation oder eine Lösch-Verifizierungsoperation durch die nichtflüchtigen Halbleiterspeicher durchgeführt wird.

11. Vorrichtung nach Anspruch 10, bei der die genannte Verifizierungs-Energie-Sourcespannungslieferschaltung (8) selektiv steuerbar ist, um eine Schreibverifizierungs-Sourcespannung (V_{WVER}) und eine Löschverifizierungs-Sourcespannung (V_{EVER}) zu erzeugen, die verschieden ist von der Schreibverifizierungs-Sourcespannung.

12. Vorrichtung nach Anspruch 11, bei der die SchreibVerifizierungs-Sourcespannung (V_{WVER}) höher ist als die normale Sourcespannung (V_{CC}) und die Lösch-Verifizierungs-Sourcespannung (V_{EVER}) nieder ist als die normale Sourcespannung (V_{CC}) .

13. Vorrichtung nach Anspruch 10, bei der das genannte externen Energiequellenmittel entweder die genannte normale Sourcespannungs-Lieferschaltung auswählt, oder die genannte Verifizierungs-Sourcespannungs-Lieferschaltung, ansprechend auf ein vorbestimmtes Steuersignal, und die genannte Verifizierungs-Sourcespannungs-Lieferschaltung ansprechend auf ein Steuersignal entweder die Schreib-Verifizierungs-Sourcespannung oder die Lösch-Verifizierungs-Sourcespannung erzeugt.

14. Vorrichtung nach Anspruch 13, bei der die Verifizierungs-Sourcespannungs-Lieferschaltung umfaßt:
Spannungsteiler (31 bis 33), um von der Schreib/Lösch-Spannung (Vₚₚ) eine erste Verifizierungsspannung abzuleiten, die geeignet ist für eine Schreib-Verifizierungsoperation, und eine zweite Verifizierungsspannung, die geeignet ist für eine Lösch-Verifizierungsoperation,
Gateschaltungen (34, 35), um die erste Verifizierungsspannung ansprechend auf ein Schreib-Verifizierungssignal (WV) hindurchzulassen, und um die zweite Verifizierungsspannung ansprechend auf ein Lösch-Verifizierungssignal (EV) hindurchzulassen, und
Schaltungen (36 bis 41), welche eine Stromspiegelkonfiguration haben, um die vorbestimmte Verifizierungs-Sourcespannung (V_{VER}) vorzusehen, welche derjenigen der ersten bzw. der zweiten Verifizierungsspannung entspricht, die durch die Gateschaltungen hindurchgelassen worden ist.

## Revendications

1. Une mémoire à semiconducteur non volatile ayant un circuit incluant une matrice (1) de cellules de mémoire effaçable non volatile (Mij) formées à des intersections de conducteurs de mot (WL1 à WLm) et de conducteurs de bit (BL11 à BL1k, ... BLn1 à BLnk), un décodeur de ligne (3), un décodeur de colonne (5) et des amplificateurs de lecture (71 à 7n) connectés aux conducteurs de bit, la mémoire à semiconducteur non volatile étant adaptée pour être connectée, pendant l'utilisation, à une structure de source d'énergie externe pour recevoir à partir de celle-ci une tension de source normale (Vcc), exigée par le circuit précité pour effectuer une opération de lecture normale sur l'une des cellules de mémoire, et une tension de source de vérification prédéterminée (W_{WVER}/V_{EVER}), exigée par le circuit précité pour effectuer une opération de vérification présélectionnée sur l'une des cellules de mémoire; et
un moyen de fourniture d'énergie pouvant fonctionner pendant une telle opération de vérification présélectionnée, de façon à fournir la tension de source de vérification reçue (W_{WVER}/V_{EVER}) au conducteur de mot ou à chaque conducteur de mot (WL1 à WLm) sélectionné dans l'opération concernée, tout en fournissant la tension de source normale reçue (V_{CC}) à des parties restantes (1-7) du circuit précité;
**caractérisée en ce que** pendant l'opération de vérification présélectionnée, le moyen de fourniture d'énergie fournit la tension de source de vérification à un transistor (14) inclus dans l'amplificateur de lecture sélectionné (7i), ou chacun d'eux, qui est utilisé pour la discrimination des données stockées dans la cellule de mémoire qui est en cours de vérification, tandis qu'il fournit la tension de source normale (V_{CC}) à des parties restantes (11, 13) de l'amplificateur de lecture sélectionné.

2. La mémoire à semiconducteur non volatile selon la revendication 1, dans laquelle une borne d'entrée de chacun des amplificateurs de lecture (7i), sur laquelle la tension de source de vérification (W_{WVER}/V_{EVER}) est appliquée à l'amplificateur de lecture concerné, a un moyen (14) pour procurer une fonction de résistance de charge.

3. La mémoire à semiconducteur non volatile selon l'une quelconque des revendications précédentes, dans laquelle chacun des amplificateurs de lecture (7i) comprend :
un élément de résistance de charge (14); et
un transistor de transmission de niveau (15) connecté en série avec l'élément de résistance de charge (14) entre la tension de source de vérification (V_{VER}) et un conducteur de données (Di) du circuit précité qui correspond à une multiplicité des conducteurs de bit (BLi1 à BLik);
un noeud, auquel l'élément de résistance de charge (14) est connecté au transistor de transmission de niveau (15), qui est connecté à une borne de sortie (I/Oi) de l'amplificateur de lecture (7i);
un transistor de transmission de niveau (15) ayant pour fonction de transmettre un niveau du conducteur de données à la borne de sortie (I/Oi); et
l'élément de résistance de charge (14) ayant pour fonction de distinguer des données de cellule sur le conducteur de données (Di) conformément à un état de conduction/blocage du transistor de transmission de niveau (15).

4. La mémoire à semiconducteur non volatile selon la revendication 3, dans laquelle :
l'élément de résistance de charge (14) est un transistor à canal p, dont la source, la grille et le drain sont respectivement connectés à la tension de source de vérification (W_{WVER}/V_{EVER}), à une tension de référence (V_{SS}), et à la borne de sortie (I/Oi) de l'amplificateur de lecture (7i); et
le transistor de transmission de niveau (15) est un transistor à canal n dont le drain, la grille et la source sont respectivement connectés à la borne de sortie (I/Oi) de l'amplificateur de lecture (7i), à un noeud fournissant une valeur inversée du niveau du conducteur de données, et au conducteur de données (Di).

5. La mémoire à semiconducteur non volatile selon la revendication 3 ou 4, comprenant en outre :
un circuit tampon (16 à 19), disposé à la sortie de l'amplificateur de lecture, et ayant la tension de source de vérification (V_{VER}) pour sa tension de source.

6. La mémoire à semiconducteur non volatile selon la revendication 3, 4 ou 5, comprenant en outre :
un élément de chute de tension (20) connecté entre la tension de source de vérification (V_{VER}) et l'élément de résistance de charge (14); et
un élément à courant constant (21) connecté entre la tension de source de vérification et la sortie de l'amplificateur de lecture.

7. La mémoire à semiconducteur non volatile selon la revendication 6, dans laquelle l'élément de chute de tension est un transistor à canal p (20) dont la grille est connectée à son drain.

8. La mémoire à semiconducteur non volatile selon la revendication 6 ou 7, dans laquelle l'élément à courant constant est un transistor à canal n (21) dont la grille est connectée à sa source.

9. La mémoire à semiconducteur non volatile selon l'une quelconque des revendications précédentes, comprenant en outre :
une source d'énergie (9) pour fournir une tension de source externe à la source de chaque transistor de chacune des cellules de mémoire non volatile.

10. Dispositif incluant :
une mémoire à semiconducteur non volatile selon l'une quelconque des revendications précédentes; et
une structure de source d'énergie externe ayant un circuit de fourniture de tension de source normale pour générer la tension de source normale (V_{CC}) et un circuit de fourniture de tension de source de vérification (8) pour générer la tension de source de vérification (W_{WVER}/V_{EVER}), le niveau de tension de la tension de source de vérification étant différent de celui de la tension de source normale, au moins lorsqu'une opération de vérification d'écriture ou une opération de vérification d'effacement est accomplie par la mémoire à semiconducteur non volatile.

11. Dispositif selon la revendication 10, dans lequel le circuit de fourniture de tension de source d'énergie de vérification (8) peut être commandé sélectivement pour générer une tension de source de vérification d'écriture (V_{WVER}) et une tension de source de vérification d'effacement (V_{EVER}) qui est différente de la tension de source de vérification d'écriture.

12. Dispositif selon la revendication 11, dans lequel la tension de source de vérification d'écriture (W_{WVER}) est supérieure à la tension de source normale (V_{CC}), et la tension de source de vérification d'effacement (V_{EVER}) est inférieure à la tension de source normale (V_{CC}).

13. Dispositif selon la revendication 10, dans lequel la structure de source d'énergie externe sélectionne soit le circuit de fourniture de tension de source normale, soit le circuit de fourniture de tension de source de vérification, en réponse à un signal de commande prédéterminé, et le circuit de fourniture de tension de source de vérification génère une tension parmi la tension de source de vérification d'écriture et la tension de source de vérification d'effacement en réponse à un signal de commande.

14. Dispositif selon la revendication 11, dans lequel le circuit de fourniture de tension de source de vérification comprend :
des diviseurs de tension (31 à 33) pour élaborer à partir d'une tension d'écriture/effacement (Vpp) une première tension de vérification convenant pour une opération de vérification d'écriture, et une seconde tension de vérification convenant pour une opération de vérification d'effacement;
des circuits de portes (34, 35) pour transmettre la première tension de vérification en réponse à un signal de vérification d'écriture (WV) et pour transmettre la seconde tension de vérification en réponse à un signal de vérification d'effacement (EV); et
des circuits (36 à 41) ayant une configuration de miroir de courant pour fournir la tension de source de vérification prédéterminée (V_{VER}) correspondant à celle des première et seconde tensions de vérification qui est transmise par les circuits de portes.
